# EUROPEAN PATENT APPLICATION

(11) **EP 2 658 100 A2**
(43) Date of publication of application: **30.10.2013**
(21) Application number: 13164816.4
(22) Date of filing: 23.04.2013
(51) Int. Cl.: H02K 11/00, H05K 7/20, H02K 29/00

(54) **Control Device and Motor Unit Including Control Device**

(30) Priority: 25.04.2012 JP 2012100040; 07.02.2013 JP 2013022540
(71) Applicant: JTEKT CORPORATION, Osaka-shi Osaka 542-8502 (JP)
(72) Inventor: TANI, Naoki, Osaka-shi,, Osaka 542-8502 (JP); NAGASE, Shigeki, Osaka-shi,, Osaka 542-8502 (JP)
(74) Representative: Winter, Brandl, Fürniss, Hübner, Röss, Kaiser, Polte - Partnerschaft

(57) **Abstract**

A control device (1B) for a motor unit (1) includes: a housing (60) including a bottom wall (62), a side wall (61) and an accommodation space (60A) formed so as to be surrounded by the side wall (61); a heat sink (70) including a first heat dissipation wall portion (71) upright from the bottom wall (62) in the accommodation space (60A), the first heat dissipation wall portion (71) having a first heat dissipation principal surface (71A); a first board portion (81) mounted on the first heat dissipation principal surface (71A) and having a first principal surface (81A); and a circuit board (80) including a power element (81C) mounted on the first principal surface (81A).

## Description

### BACKGROUND OF THE INVENTION

### 1. Field of the Invention

The invention relates to a control device that includes a heat sink and a circuit board, and a motor unit including the control device.

### 2. Description of Related Art

A control device described in Japanese Patent Application Publication No. 2008-41718 (JP 2008-41718 A) includes a housing, a planar single circuit board and a plurality of circuit elements. The circuit board is mounted on the bottom wall of the housing. The circuit elements are mounted on the circuit board.

In the above-described control device, all the circuit elements are mounted on the planar single circuit board. Therefore, it is difficult to reduce the size of the circuit board in the plane direction. Thus, for example, when the control device is mounted on an electric motor, the circuit board may project outward beyond the edge of the housing of the electric motor.

### SUMMARY OF THE INVENTION

The invention provides a control device that allows a reduction in size in the plane direction of a bottom wall of a housing, and a motor unit including the control device.

A first aspect of the invention provides a control device. The control device includes: a housing having a bottom wall, a side wall upright from the bottom wall, and an accommodation space formed so as to be surrounded by the side wall; a heat sink accommodated in the accommodation space, and including a first heat dissipation wall portion having a first heat dissipation principal surface; and a circuit board including a first board portion connected to the first heat dissipation principal surface and having a first principal surface, and a power element mounted on the first principal surface.

With the above-described control device, the first board portion of the circuit board is mounted on the first heat dissipation principal surface, so it is possible to reduce the size of the circuit board in the plane direction of the bottom wall. In addition, heat of the power element is transferred to the heat sink via the first board portion. Therefore, a rise in the temperature of the power element is suppressed.

In the control device according to the above aspect, the heat sink may be accommodated in the accommodation space, and may include a second heat dissipation wall portion having a second heat dissipation principal surface, and the circuit board may include: a second board portion connected to the second heat dissipation principal surface and having a second principal surface; and a first coupling portion that couples the first board portion and the second board portion to each other.

In the control device according to the above aspect, the first heat dissipation wall portion may have a rectangular shape and is upright from the bottom wall, and may include: a first heat dissipation back surface that constitutes a surface across the first heat dissipation wall portion from the first heat dissipation principal surface; and a first one end portion and a first other end portion extending in a direction in which the first heat dissipation wall portion is upright from the bottom wall, the second heat dissipation wall portion may have a rectangular shape and is upright from the bottom wall, and may include: a second heat dissipation back surface that constitutes a surface across the second heat dissipation wall portion from the second heat dissipation principal surface; and a second one end portion and a second other end portion extending in a direction in which the second heat dissipation wall portion is upright from the bottom wall, the second one end portion being located adjacent to the first other end portion, and the heat sink may include a first coupling wall portion that couples the first other end portion and the second one end portion to each other, and that bends in a direction in which the first heat dissipation back surface and the second heat dissipation back surface face each other.

With the above-described control device, the first heat dissipation wall portion and the second heat dissipation wall portion are coupled by the first coupling wall portion, so heat transfer occurs between the first heat dissipation wall portion and the second heat dissipation wall portion. Therefore, the amount of heat that the heat sink is able to receive from the first board portion increases.

In the control device according to the above aspect, the heat sink may be accommodated in the accommodation space, and may include a third heat dissipation wall portion having a third heat dissipation principal surface, and the circuit board may include: a third board portion mounted on the third heat dissipation principal surface and having a third principal surface; and a second coupling portion that couples the first board portion and the third board portion to each other.

In the control device according to the above aspect, the third heat dissipation wall portion may have a rectangular shape and may be upright from the bottom wall, and may include: a third heat dissipation back surface that constitutes a surface across the third heat dissipation wall portion from the third heat dissipation principal surface; and a third one end portion and a third other end portion extending in a direction in which the third heat dissipation wall portion is upright from the bottom wall, the third one end portion being located adjacent to the first one end portion, the third heat dissipation back surface facing the second heat dissipation back surface via a space, and the heat sink may include a second coupling wall portion that couples the first one end portion and the third one end portion to each other, and that bends in a direction in which the first heat dissipation back surface and the third heat dissipation back surface face each other.

In the control device according to the above aspect, the circuit board may include another power element on the second principal surface, and may include a control element on the third principal surface.

A second aspect of the invention provides a control device. The control device includes: a housing having a bottom wall, a side wall upright from the bottom wall, and an accommodation space formed so as to be surrounded by the side wall; a heat sink accommodated in the accommodation space, and including a first heat dissipation wall portion having a first heat dissipation principal surface and a second heat dissipation wall portion having a second heat dissipation principal surface; and a circuit board including a first circuit board mounted on the first heat dissipation principal surface and having a first principal surface, a second circuit board mounted on the second heat dissipation principal surface and having a second principal surface, and a power element mounted on the first principal surface.

With the above-described control device, the first board portion of the circuit board is mounted on the first heat dissipation principal surface and the second board portion is mounted on the second heat dissipation principal surface, so it is possible to reduce the size of the circuit board in the plane direction of the bottom wall. In addition, heat of the power element is transferred to the heat sink via the first board portion. Therefore, a rise in the temperature of the power element is suppressed.

A third aspect of the invention provides a motor unit that includes the control device according to the above aspects.

A fourth aspect of the invention provides a control device that drives a three-phase brushless motor. The control device includes: a housing having a bottom wall, a side wall upright from the bottom wall, and an accommodation space formed so as to be surrounded by the side wall; a heat sink accommodated in the housing, and including a heat dissipation wall portion having a heat dissipation principal surface; a circuit board mounted on the heat dissipation principal surface, and including a plurality of board portions each having a principal surface; and a plurality of inverter circuits formed on the principal surfaces for driving the three-phase brushless motor in multiple systems, wherein the circuit board includes the board portions in number larger than or equal to three times of the number of the systems in which the three-phase brushless motor is driven, and switching elements of the phases of the inverter circuits are respectively mounted on the principal surfaces of the board portions.

With the above-described control device, the board portions of the circuit board are mounted on the heat dissipation principal surfaces of the heat sink, so it is possible to reduce the size of the circuit board in the plane direction of the bottom wall. In addition, heat of the switching elements is transferred to the heat sink via the board portions. Therefore, a rise in the temperature of the switching elements is suppressed.

In the control device according to the above aspect, the circuit board may include a board portion having a principal surface to which a connector for supplying electric power to the three-phase brushless motor is mounted.

In the control device according to the above aspect, the circuit board may include coupling portions, each of which couples the adjacent board portions.

A fifth aspect of the invention provides a motor unit that includes: a three-phase brushless motor; and the control device according to the above aspect, wherein the three-phase brushless motor includes a stator, the plurality of inverter circuits include a first inverter circuit and a second inverter circuit, the stator includes a first drive stator that is energized via the first inverter circuit and a second drive stator that is energized via the second inverter circuit, the stator is split into the first drive stator and the second drive stator in a circumferential direction of the three-phase brushless motor, the board portions that constitute the first inverter circuit among the board portions are arranged at the same location in the circumferential direction as the first drive stator, and the board portions that constitute the second inverter circuit among the board portions are arranged at the same location in the circumferential direction as the second drive stator.

With the above-described motor unit, for example, it is possible to bring the distance between the U-phase stator of the first drive stator and the board portion on which the U-phase switching element is mounted close to the distance between the V-phase stator of the first drive stator and the board portion on which the V-phase switching element is mounted. Therefore, variations in connection distance between the phase stators and the circuit board between the first inverter circuit and the first drive stator are suppressed. A similar advantageous effect is obtained for the relationship between the second inverter circuit and the second drive stator.

According to the above aspects of the invention, it is possible to provide the control device that allows a reduction in size in the plane direction of the bottom wall of the housing, and the motor unit including the control device.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a sectional view of a motor unit according to a first embodiment of the invention, and is a sectional view that shows a sectional structure along a plane in an axial direction;
FIG. 2 is a sectional view of the motor unit according to the first embodiment, and is a sectional view that shows a sectional structure along the Z1-Z1 plane in FIG. 1;
FIG. 3 is a developed view that shows a developed structure of a circuit board according to the first embodiment;
FIG. 4 is a perspective view of a control device according to a second embodiment of the invention, and is a perspective view that shows an external perspective structure;
FIG. 5 is a plan view of the control device according to the second embodiment, and is a plan view that shows a planar structure in a state where a cover is removed;
FIG. 6 is a circuit diagram that shows the circuit structure of a control device of a motor unit according to a third embodiment;
FIG. 7 is a sectional view of the motor unit according to the third embodiment, and is a sectional view that shows a sectional structure along a plane in an axial direction;
FIG. 8 is a sectional view of the motor unit according to the third embodiment, and is a sectional view that shows a sectional structure along the Z7-Z7 plane in FIG. 7;
FIG. 9 is a developed view that shows a developed structure of a circuit board according to the third embodiment;
FIG. 10 is a sectional view of a motor unit according to an alternative embodiment of the invention, and is a sectional view that shows a sectional structure along an axial direction;
FIG. 11 is a sectional view of the motor unit according to the alternative embodiment of the invention, and is a sectional view that shows a sectional structure along the Z10-Z10 plane in FIG. 10; and
FIG. 12 is a sectional view of the motor unit according to an alternative embodiment of the invention, and is a sectional view that shows a sectional structure along an axial direction.

### DETAILED DESCRIPTION OF EMBODIMENTS

### First Embodiment

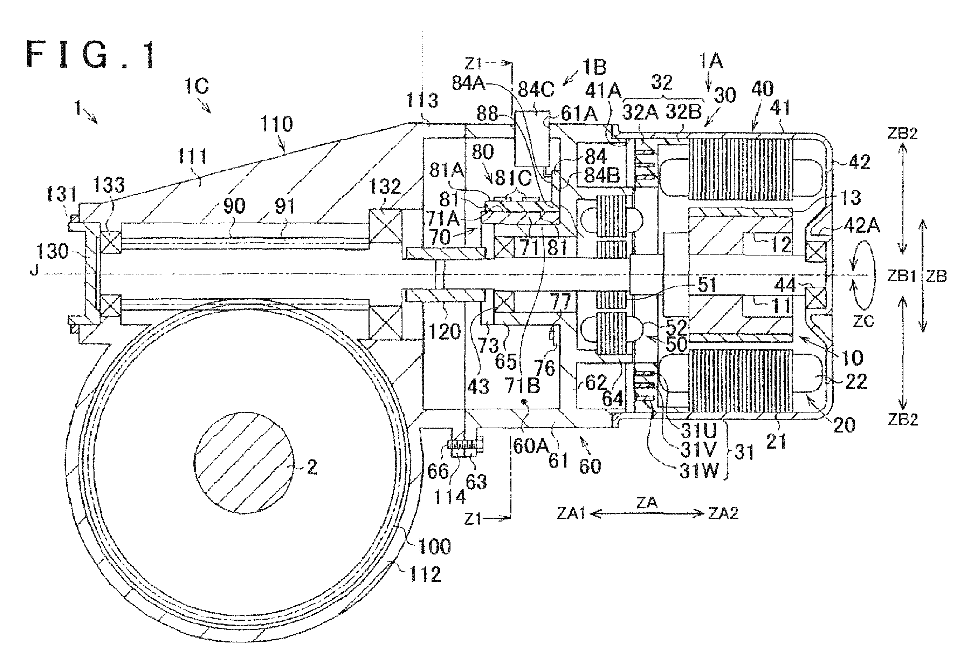

The configuration of a motor unit 1 according to the present embodiment will be described with reference to FIG. 1. The motor unit 1 according to the present embodiment is applied to an electric power steering (hereinafter, "EPS"). The EPS detects a steering torque at the time when a driver operates a steering member (not shown), and controls an electric motor 1A of the motor unit 1 such that an assist torque corresponding to the steering torque is generated. The EPS transmits the rotation of the steering member to a rack-and-pinion mechanism (not shown) via a steering shaft 2, and converts the rotation to the reciprocating movement of a rack shaft (not shown).

The motor unit 1 includes the electric motor 1A, a control device 1B and a speed reducer 1C. The electric motor 1A serves as a three-phase brushless motor. In the motor unit 1, the control device 1B is located between the electric motor 1A and the speed reducer 1C.

The electric motor 1A includes a rotor 10, a stator 20, a bus bar 30, a motor housing 40, ball bearings 43, 44 and a resolver 50. The control device 1B includes a housing 60, a heat sink 70 and a circuit board 80. The control device 1B controls the operation of the electric motor 1A. The speed reducer 1C includes a worm shaft 90, a worm wheel 100 and a gear housing 110. The speed reducer 1C transmits the running torque of an output shaft 11 of the electric motor 1A to the steering shaft 2 in a state where the rotation speed of the output shaft 11 is reduced.

The directions of the motor unit 1 are defined as follows.
(A) An "axial direction ZA" indicates a direction along a central axis (hereinafter, "central axis J") of the rotor 10. A "radial direction ZB" indicates a direction perpendicular to the axial direction ZA. A "circumferential direction ZC" indicates a direction in which the rotor 10 rotates.
(B) A "distal end direction ZA1" indicates a direction that passes through the electric motor 1A, the control device 1B and the speed reducer 1C sequentially in the axial direction ZA. A "proximal end direction ZA2" indicates a direction that passes through the speed reducer 1C, the control device 1B and the electric motor 1A sequentially in the axial direction ZA.
(C) An "inward direction ZB1" indicates a direction that approaches the central axis J in the radial direction ZB. An "outward direction ZB2" indicates a direction that distances from the central axis J in the radial direction ZB.

The rotor 10 includes the output shaft 11, a rotor core 12 and a permanent magnet 13. The rotor core 12 has a cylindrical shape. The rotor core 12 is press-fitted to the output shaft 11. The permanent magnet 13 is fixed to the outer periphery of the rotor core 12. The permanent magnet 13 has ten magnetic poles in the circumferential direction ZC.

The stator 20 includes a stator core 21 and a field unit 22. The stator 20 forms a magnetic field for generating the rotation force of the rotor 10 with currents that are supplied from a power supply (not shown) to conductive lines. Magnetic fluxes of the field unit 22 pass through the stator core 21. The stator core 21 is press-fitted to the inner periphery of a stator holding portion 41 of the motor housing 40. The field unit 22 forms concentrated windings by winding conductive lines around the stator core 21. The field unit 22 includes four U-phase coils, four V-phase coils and four W-phase coils.

The bus bar 30 includes copper plates 31 and a support member 32. The bus bar 30 is connected to the stator core 21 at a location in the distal end direction ZA1 with respect to the stator core 21. The bus bar 30 electrically connects the stator 20 and the circuit board 80 to each other.

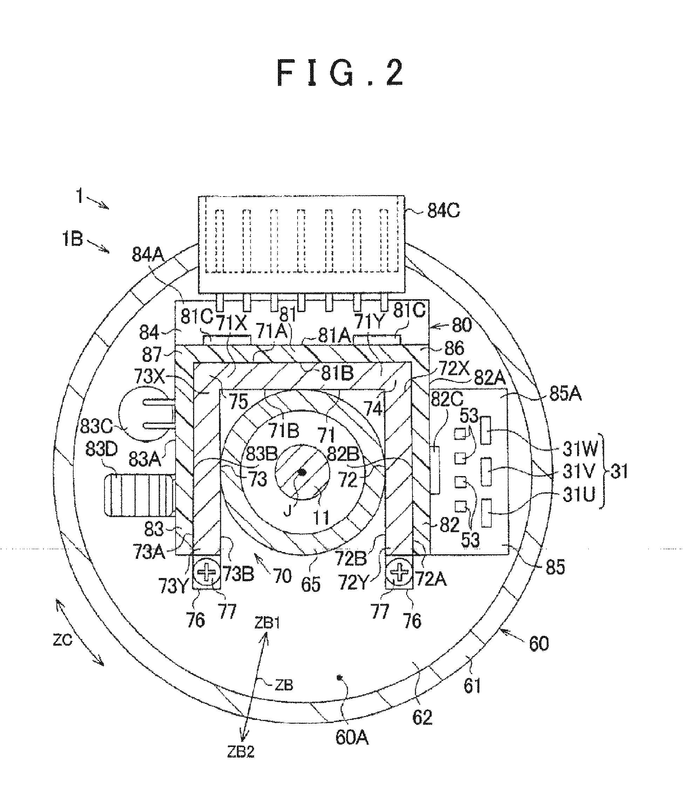

The copper plates 31 include a U-phase copper plate 31U, a V-phase copper plate 31V and a W-phase copper plate 31W. Coil end portions of the U-phase coils are connected to the U-phase copper plate 31U. Coil end portions of the V-phase coils are connected to the V-phase copper plate 31V Coil end portions of the W-phase coils are connected to the W-phase copper plate 31W. The end portions of the phase copper plates 31U, 31V, 31W extend in the distal end direction ZA1, and are connected to the circuit board 80 (see FIG. 2).

The support member 32 has a copper plate support portion 32A and three leg portions 32B. The support member 32 has such a structure that the copper plate support portion 32A and the leg portions 32B are integrally molded from the same resin material. The copper plate support portion 32A has an annular shape. The copper plate support portion 32A supports the copper plates 31. The leg portions 32B extend in the proximal end direction ZA2 from the outer peripheral portion of the copper plate support portion 32A. The leg portions 32B are spaced apart from each other in the circumferential direction ZC. The leg portions 32B are connected to the outer peripheral portion of the stator core 21 at their end portions in the proximal end direction ZA2.

The motor housing 40 has the stator holding portion 41 and a cover portion 42. The motor housing 40 has such a structure that the stator holding portion 41 and the cover portion 42 are integrally formed from the same metal plate. The motor housing 40 accommodates part of the rotor 10, the stator 20 and the bus bar 30.

The stator holding portion 41 has a cylindrical shape. The stator holding portion 41 has an opening portions 41A that opens in the distal end direction ZA1 at the end portion in the distal end direction ZA1. The cover portion 42 has a bearing support portion 42A. The cover portion 42 closes the end portion of the stator holding portion 41 in the proximal end direction ZA2.

The ball bearing 43 is fixed to the distal end portion of the output shaft 11 and the bearing support portion 65. The ball bearing 43 supports the output shaft 11 in a state where the rotor 10 is rotatable relative to the stator 20.

The ball bearing 44 is fixed to the proximal end portion of the output shaft 11 and the bearing support portion 42A. The ball bearing 44 supports the output shaft 11 in a state where the rotor 10 is rotatable relative to the stator 20.

The resolver 50 is located in the distal end direction ZA1 with respect to the bus bar 30 and in the inward direction ZB1 with respect to the bus bar 30, The resolver 50 outputs a voltage signal, corresponding to the rotation position of the rotor 10, to the circuit board 80. The resolver 50 includes a resolver rotor 51, a resolver stator 52 and a circuit connection member 53 (see FIG. 2). The resolver 50 is a variable-reluctance resolver.

The resolver rotor 51 is press-fitted to the output shaft 11. The resolver stator 52 is fixed to a resolver support portion 64. The resolver stator 52 is press-fitted to the resolver support portion 64. The circuit connection member 53 is formed of a terminal base and a plurality of pin terminals. The terminal base protrudes in the radial direction ZB from the resolver stator 52. In the circuit connection member 53, the pin terminals are upright in the distal end direction ZA1 from the terminal base. The circuit connection member 53 is arranged at the same location as an external connector 84C in the circumferential direction ZC. The circuit connection member 53 is connected to the circuit board 80 (see FIG. 2). The circuit connection member 53 electrically connects the resolver stator 52 and the circuit board 80 to each other.

The housing 60 has an accommodation space 60A, a side wall 61, a bottom wall 62, a mounting portion 63, the resolver support portion 64 and the bearing support portion 65. The housing 60 has such a structure that the side wall 61, the bottom wall 62, the mounting portion 63, the resolver support portion 64 and the bearing support portion 65 are integrally molded from the same metal material. The housing 60 has the accommodation space 60A as a space surrounded by the bottom wall and the side wall.

The side wall 61 has a cylindrical shape. The side wall 61 is fixed to the opening portion 41A of the motor housing 40. The side wall 61 has a connector insertion portion 61A. The bottom wall 62 is located in the middle portion of the side wall 61 in the axial direction ZA. The bottom wall 62 closes the opening portion 41A. The bottom wall 62 has a bus bar through-hole and a resolver through-hole (both are not shown). The mounting portion 63 is fixed to the mounting portion 114 of the gear housing 110 by bolts 66. The resolver support portion 64 has a cylindrical shape. The resolver support portion 64 extends in the proximal end direction ZA2 from the bottom wall 62. The bearing support portion 65 has a cylindrical shape. The bearing support portion 65 is located in the inward direction ZB1 with respect to the resolver support portion 64. The bearing support portion 65 extends in the distal end direction ZA1 from the bottom wall 62.

The heat sink 70 is formed of aluminum. The heat sink 70 has a substantially U shape in plan view (see FIG. 2). The heat sink 70 is accommodated in the accommodation space 60A of the housing 60. The heat sink 70 is fixed to the bottom wall 62, and is upright in the distal end direction ZA1 from the bottom wall 62. The heat sink 70 surrounds the output shaft 11 and the bearing support portion 65 from a side in the outward direction ZB2.

The circuit board 80 is fixed to the heat sink 70. The circuit board 80 is formed as a multilayer printed circuit board in which a plurality of thermoplastic films are laminated. The circuit board 80 has through-holes and inter-layer connecting portions (not shown) formed of electrically conductive paste filled in the through-holes. The circuit board 80 is formed by thermo-compression bonding in a state where the thermoplastic films having conductor patterns and electrically conductive paste are laminated.

The worm shaft 90 rotates integrally with the output shaft 11. The worm shaft 90 has a gear portion 91. The worm shaft 90 is in mesh with the worm wheel 100 at the gear portion 91. The worm shaft 90 is coupled to the output shaft 11 by a connection member 120 fixed to the proximal end portion of the worm shaft 90.

The worm wheel 100 is fixed to the steering shaft 2. The worm wheel 100 transmits the rotation of the worm shaft 90 to the steering shaft 2. The gear housing 110 accommodates the worm shaft 90 and the worm wheel 100. The gear housing 110 has a shaft accommodation portion 111, a wheel accommodation portion 112, a side wall 113 and the mounting portion 114. The gear housing 110 has such a configuration that a cover member 130, a lock nut 131 and ball bearings 132, 133 are mounted on the shaft accommodation portion 111.

The shaft accommodation portion 111 accommodates the worm shaft 90. The wheel accommodation portion 112 accommodates the worm wheel 100 and part of the steering shaft 2. The side wall 113 has a cylindrical shape. The side wall 113 is located at the end portion of the gear housing 110 in the proximal end direction ZA2. The mounting portion 114 faces the mounting portion 63 in a state where the gear housing 110 is mounted on the housing 60.

The cover member 130 is fixed to the distal end portion of the shaft accommodation portion 111. The cover member 130 has an external screw thread (not shown) at its outer periphery. The external screw thread is in mesh with an internal screw thread (not shown) formed in the gear housing 110.

The lock nut 131 is meshed with the external screw thread of the cover member 130. The lock nut 131 suppresses looseness of the cover member 130 with respect to the gear housing 110.

The ball bearing 132 is fixed to the proximal end portion of the worm shaft 90 and the end portion of the shaft accommodation portion 111 in the proximal end direction ZA2. The ball bearing 132 supports the worm shaft 90 in a state where the worm shaft 90 is rotatable relative to the gear housing 110.

The ball bearing 133 is fixed to the distal end portion of the worm shaft 90 and the distal end portion of the shaft accommodation portion 111. The ball bearing 133 supports the worm shaft 90 in a state where the worm shaft 90 is rotatable relative to the gear housing 110.

The detailed configuration of the heat sink 70 will be described with reference to FIG. 2. The heat sink 70 includes a first heat dissipation wall portion 71, a second heat dissipation wall portion 72, a third heat dissipation wall portion 73, a first coupling wall portion 74, a second coupling wall portion 75 and fixing portions 76. The heat sink 70 has such a structure that the first heat dissipation wall portion 71, the second heat dissipation wall portion 72, the third heat dissipation wall portion 73, the first coupling wall portion 74, the second coupling wall portion 75 and the fixing portions 76 are integrally molded.

The first heat dissipation wall portion 71 has a rectangular shape. The first heat dissipation wall portion 71 extends in the axial direction ZA from the bottom wall 62. The first heat dissipation wall portion 71 has a first heat dissipation principal surface 71A, a first heat dissipation back surface 71B, a first one end portion 71X and a first other end portion 71Y.

The first heat dissipation back surface 71B forms a surface across the first heat dissipation wall portion 71 from the first heat dissipation principal surface 71A, and is located between the first heat dissipation principal surface 71A and the output shaft 11. The first one end portion 71X and the first other end portion 71Y extend in the axial direction ZA. The first one end portion 71X is formed in the first heat dissipation wall portion 71 at a location spaced apart from the second heat dissipation wall portion 72. The first other end portion 71Y is formed in the first heat dissipation wall portion 71 at a location close to the second heat dissipation wall portion 72.

The second heat dissipation wall portion 72 has a rectangular shape. The second heat dissipation wall portion 72 extends in the axial direction ZA from the bottom wall 62. The second heat dissipation wall portion 72 is perpendicular to the first heat dissipation wall portion 71. The second heat dissipation wall portion 72 has a second heat dissipation principal surface 72A, a second heat dissipation back surface 72B, a second one end portion 72X and a second other end portion 72Y.

The second heat dissipation back surface 72B forms a surface across the second heat dissipation wall portion 72 from the second heat dissipation principal surface 72A, and is located between the second heat dissipation principal surface 72A and the output shaft 11. The second one end portion 72X and the second other end portion 72Y extend in the axial direction ZA. The second one end portion 72X is formed in the second heat dissipation wall portion 72 at a location close to the first heat dissipation wall portion 71. The second one end portion 72X is adjacent to the first other end portion 71Y The second other end portion 72Y is formed in the second heat dissipation wall portion 72 at a location spaced apart from the first heat dissipation wall portion 71.

The third heat dissipation wall portion 73 has a rectangular shape. The third heat dissipation wall portion 73 extends in the axial direction ZA from the bottom wall 62. The third heat dissipation wall portion 73 is perpendicular to the first heat dissipation wall portion 71, and is parallel to the second heat dissipation wall portion 72. The third heat dissipation wall portion 73 is located at the side across the output shaft 11 from the side at which the second heat dissipation wall portion 72 is located. The third heat dissipation wall portion 73 has a third heat dissipation principal surface 73A, a third heat dissipation back surface 73B, a third one end portion 73X and a third other end portion 73Y.

The third heat dissipation back surface 73B forms a surface across the third heat dissipation wall portion 73 from the third heat dissipation principal surface 73A, and is located between the third heat dissipation principal surface 73A and the output shaft 11. The third one end portion 73X and the third other end portion 73Y extend in the axial direction ZA. The third one end portion 73X is formed in the third heat dissipation wall portion 73 at a location close to the first heat dissipation wall portion 71. The third one end portion 73X is adjacent to the first one end portion 71X. The third other end portion 73Y is formed in the third heat dissipation wall portion 73 at a location spaced apart from the first heat dissipation wall portion 71.

The first coupling wall portion 74 is located between the first other end portion 71Y and the second one end portion 72X. The first coupling wall portion 74 couples the first other end portion 71Y and the second one end portion 72X to each other. The first coupling wall portion 74 bends in a direction in which the first heat dissipation back surface 71B and the second heat dissipation back surface 72B face each other.

The second coupling wall portion 75 is located between the first one end portion 71X and the third one end portion 73X. The second coupling wall portion 75 couples the first one end portion 71X and the third one end portion 73X to each other. The second coupling wall portion 75 bends in a direction in which the first heat dissipation back surface 71B and the third heat dissipation back surface 73B face each other.

The fixing portions 76 each have a rectangular shape. The fixing portions 76 respectively protrude from the end portion of the second other end portion 72Y in the proximal end direction ZA2 and the end portion of the third other end portion 73Y in the proximal end direction ZA2. The fixing portions 76 are fixed to the bottom wall 62 by bolts 77.

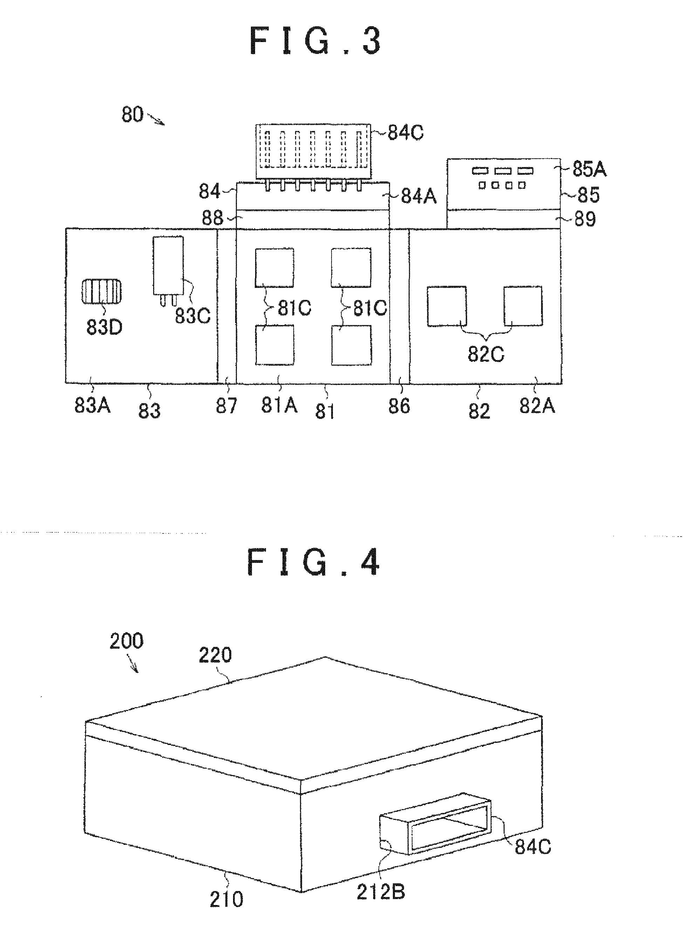

The detailed configuration of the circuit board 80 will be described with reference to FIG. 2 and FIG. 3. The circuit board 80 includes a first board portion 81, a second board portion 82, a third board portion 83, a fourth board portion 84, a fifth board portion 85, a first coupling portion 86, a second coupling portion 87, a third coupling portion 88 (see FIG. 3) and a fourth coupling portion 89 (see FIG. 3). The circuit board 80 has such a structure that the first board portion 81, the second board portion 82, the third board portion 83, the fourth board portion 84, the fifth board portion 85, the first coupling portion 86, the second coupling portion 87, the third coupling portion 88 and the fourth coupling portion 89 are integrally molded.

The first board portion 81 has a rectangular shape. The first board portion 81 has a first principal surface 81A, a first back surface 81B and four field-effect transistors that serve as power elements 81C. The first back surface 81B of the first board portion 81 is fixed to the first heat dissipation principal surface 71A of the first heat dissipation wall portion 71. In the first board portion 81, the power elements 81C are mounted on the first principal surface 81A. The first board portion 81 has such a structure that the first principal surface 81A and the first back surface 81B are oriented in the axial direction ZA. The first board portion 81 constitutes part of an inverter circuit with the use of the power elements 81C.

The second board portion 82 has a rectangular shape. The second board portion 82 has a second principal surface 82A, a second back surface 82B, and two field-effect transistors that serve as power elements 82C. The second back surface 82B of the second board portion 82 is fixed to the second heat dissipation principal surface 72A of the second heat dissipation wall portion 72. In the second board portion 82, the power elements 82C are mounted on the second principal surface 82A. The second board portion 82 has such a structure that the second principal surface 82A and the second back surface 82B are oriented in the axial direction ZA. The second board portion 82 constitutes part of the inverter circuit with the use of the power elements 82C.

The third board portion 83 has a rectangular shape. The third board portion 83 has a third principal surface 83A, a third back surface 83B, an electrolytic capacitor that serves as a control element 83C, and a toroidal coil that serves as a control element 83D. The third back surface 83B of the third board portion 83 is fixed to the third heat dissipation principal surface 73A of the third heat dissipation wall portion 73. In the third board portion 83, the control element 83C is mounted on the third principal surface 83A. The third board portion 83 has such a structure that the third principal surface 83A and the third back surface 83B are oriented in the axial direction ZA. The third board portion 83 constitutes part of a control circuit for controlling the inverter circuit.

The fourth board portion 84 has a rectangular shape. The fourth board portion 84 has a fourth principal surface 84A, a fourth back surface 84B (see FIG. 1) and the external connector 84C. The fourth back surface 84B of the fourth board portion 84 is fixed to the surface of the bottom wall 62 at the side in the distal end direction ZA1. The fourth board portion 84 is adjacent to the first board portion 81. In the fourth board portion 84, the external connector 84C is mounted on the fourth principal surface 84A. The fourth board portion 84 has such a structure that the fourth principal surface 84A and the fourth back surface 84B are oriented in the radial direction ZB.

The fifth board portion 85 has a rectangular shape. The fifth board portion 85 has a fifth principal surface 85A and a fifth back surface (not shown). The fifth board portion 85 is fixed to the bottom wall 62 at the fifth back surface. The end portions of the copper plates 31 of the bus bar 30 and the end portion of the circuit connection member 53 of the resolver 50 are electrically connected to the fifth board portion 85. The fifth board portion 85 has such a structure that the fifth principal surface 85A and the fifth back surface are oriented in the radial direction ZB.

The first coupling portion 86 is located between the first board portion 81 and the second board portion 82. The first coupling portion 86 faces the first coupling wall portion 74. The first coupling portion 86 connects the first board portion 81 and the second board portion 82 to each other. The first coupling portion 86 bends in a direction in which the first back surface 81B and the second back surface 82B face each other.

The second coupling portion 87 is located between the second board portion 82 and the third board portion 83. The second coupling portion 87 faces the second coupling wall portion 75. The second coupling portion 87 couples the second board portion 82 and the third board portion 83 to each other. The second coupling portion 87 bends in a direction in which the second back surface 82B and the third back surface 83B face each other.

The third coupling portion 88 (see FIG. 3) is located between the first board portion 81 and the fourth board portion 84. The third coupling portion 88 couples the first board portion 81 and the fourth board portion 84 to each other. The third coupling portion 88 bends in a direction in which the first principal surface 81A and the fourth principal surface 84A face each other.

The fourth coupling portion 89 (see FIG. 3) is located between the second board portion 82 and the fifth board portion 85. The fourth coupling portion 89 couples the second board portion 82 and the fifth board portion 85 to each other. The fourth coupling portion 89 bends in a direction in which the second principal surface 82A and the fifth principal surface 85A face each other.

A manufacturing method for the control device 1B will be described with reference to FIG. 2. The manufacturing method for the control device 1B includes a circuit board unit assembling process and a circuit board unit installation process.

In the circuit board unit assembling process, a unit into which the heat sink 70 and the circuit board 80 are assembled together (hereinafter, "circuit board unit") is manufactured. Specifically, adhesive agent is applied to the first heat dissipation principal surface 71A, second heat dissipation principal surface 72A and third heat dissipation principal surface 73A of the heat sink 70. Then, the first board portion 81 is mounted on the first heat dissipation principal surface 71A, the second board portion 82 is mounted on the second heat dissipation principal surface 72A, and the third board portion 83 is mounted on the third heat dissipation principal surface 73A. After that, a relative position between the first board portion 81 and the fourth board portion 84 is changed by bending the third coupling portion 88. In addition, a relative position between the second board portion 82 and the fifth board portion 85 is changed by bending the fourth coupling portion 89. A process in which the third coupling portion 88 and the fourth coupling portion 89 are bent may be performed before the circuit board 80 is connected to the heat sink 70.

In the circuit board unit installation process, the circuit board unit is arranged in the accommodation space 60A of the housing 60. Then, in a state where the heat sink 70 is placed on the bottom wall 62, the heat sink 70 is fixed to the bottom wall 62 by the bolts 77. In addition, the fifth board portion 85 is connected to the end portions of the copper plates 31 of the bus bar 30 and the end portion of the circuit connection member 53 of the resolver 50 by soldering. In this way, the circuit board unit is manufactured in advance and then the circuit board unit is installed in the housing 60, so, in comparison with a method in which it is assumed that the heat sink 70 is fixed to the bottom wall 62 and then the circuit board 80 is fixed to the heat sink 70, the heat sink 70 and the circuit board 80 are easily installed in the housing 60.

The operation of the control device 1B will be described with reference to FIG. 2. In the control device 1B, the first board portion 81, the second board portion 82 and the third board portion 83 are respectively fixed to the first heat dissipation principal surface 71A of the first heat dissipation wall portion 71, the second heat dissipation principal surface 72A of the second heat dissipation wall portion 72 and the third heat dissipation principal surface 73A of the third heat dissipation wall portion 73 in the heat sink 70 that is upright from the bottom wall 62. Therefore, the first board portion 81, the second board portion 82 and the third board portion 83 are upright with respect to the radial direction ZB that is the plane direction of the bottom wall 62. Thus, in comparison with a configuration that it is assumed that the first board portion 81, the second board portion 82 and the third board portion 83 are formed as a single planar shape and fixed to the bottom wall 62, it is possible to reduce the size of the circuit board 80 in the radial direction ZB.

The second heat dissipation wall portion 72 is perpendicular to the first heat dissipation wall portion 71, and the third heat dissipation wall portion 73 is perpendicular to the first heat dissipation wall portion 71, so the second board portion 82 is perpendicular to the first board portion 81, and the third board portion 83 is perpendicular to the first board portion 81. Therefore, in comparison with a configuration that it is assumed that the first board portion 81, the second board portion 82 and the third board portion 83 are formed as a single planar shape, it is possible to reduce the size of the circuit board 80 in the radial direction ZB.

Heat dissipation of the power elements 81C will be described. When the motor unit 1 is driven, the power elements 81C of the first board portion 81 generate heat. At this time, heat of the power elements 81C is transferred to the first heat dissipation wall portion 71 via the first board portion 81. Then, heat transferred to the first heat dissipation wall portion 71 is transferred to the bottom wall 62. In this way, heat of the power elements 81C is transferred to the outside of the power elements 81C, so a rise in the temperature of the power elements 81C is suppressed. Similar heat dissipation occurs in the power elements 82C of the second board portion 82 and the control element 83C of the third board portion 83, so the description thereof is omitted.

The motor unit 1 according to the present embodiment has the following advantageous effects.
(1) In the control device 1B, the heat sink 70 has the first heat dissipation wall portion 71 that is upright from the bottom wall 62, and the circuit board 80 includes the first board portion 81 mounted on the first heat dissipation principal surface 71A of the first heat dissipation wall portion 71, the first board portion 81 having the power elements 81C. With this configuration, it is possible to reduce the size of the circuit board 80 in the radial direction ZB that is the plane direction of the bottom wall 62. In addition, heat of the power elements 81C is transferred to the heat sink 70 via the first board portion 81. Therefore, a rise in the temperature of the power elements 81C is suppressed.

(2) In the control device 1B, the heat sink 70 includes the second heat dissipation wall portion 72 and the first coupling wall portion 74 that couples the first heat dissipation wall portion 71 and the second heat dissipation wall portion 72 to each other. With this configuration, heat transfer occurs between the first heat dissipation wall portion 71 and the second heat dissipation wall portion 72. Therefore, the amount of heat that the heat sink 70 is able to receive from the first board portion 81 increases. In addition, the amount of heat that the heat sink 70 is able to receive from the second board portion 82 increases.

(3) In the control device 1B, the second board portion 82 and the third board portion 83 are parallel to each other, and are perpendicular to the first board portion 81. With this configuration, in comparison with a configuration that it is assumed that the first board portion 81, the second board portion 82 and the third board portion 83 form a single planar shape, it is possible to reduce the size of the circuit board 80 in the radial direction ZB.

(4) In the control device 1B, the control elements 83C, 83D are mounted on the third principal surface 83A of the third board portion 83. With this configuration, heat of the control elements 83C, 83D is transferred to the heat sink 70 via the third board portion 83. Therefore, a rise in the temperature of the control elements 83C, 83D is suppressed.

### Second Embodiment

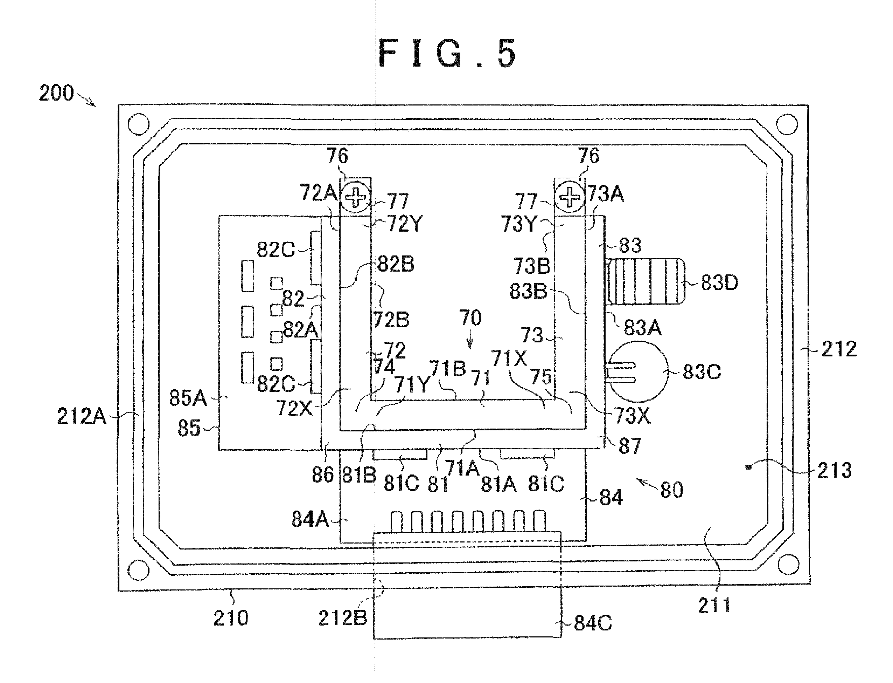

FIG. 4 and FIG. 5 show the configuration of a control device 200 according to the present embodiment. The control device 200 according to the present embodiment differs from the control device 1B (see FIG. 1) according to the first embodiment in that the control device 200 is separately formed from the electric motor 1A (see FIG. 1). Hereinafter, the details of the difference from the control device 1B according to the first embodiment will be described, like reference numerals denote components common to the first embodiment, and part or all of the description is omitted.

As shown in FIG. 4, the control device 200 has a rectangular parallelepiped shape. As shown in FIG. 5, the control device 200 includes the heat sink 70, the circuit board 80, a housing 210 and a cover 220.

The housing 210 is formed of a metal material. The housing 210 has a box shape having a rectangular shape in plan view. The housing 210 has a bottom wall 211, a side wall 212 and an accommodation space 213. The housing 210 accommodates the heat sink 70 and the circuit board 80 in the accommodation space 213. The housing 210 has such a structure that the bottom wall 211 and the side wall 212 are integrally molded from the same metal material. The side wall 212 has a fitting protrusion 212A and a connector insertion portion 212B. The fitting protrusion 212A protrudes from the end face of the side wall 212. The connector insertion portion 212B is formed as a through-hole that extends through the side wall 212 in the thickness direction.

The cover 220 covers the side wall 212 across from the bottom wall 211. The cover 220 is fixed to the side wall 212 by bolts (not shown). The cover 220 has a fitting recess (not shown). The fitting recess is fitted to the fitting protrusion 212A in a state where the cover 220 is attached to the housing 210.

The heat sink 70 is fixed to the bottom wall 211 of the housing 210. The heat sink 70 is upright from the bottom wall 211 in the accommodation space 213. In the circuit board 80, the fourth board portion 84 and the fifth board portion 85 are fixed to the bottom wall 211 of the housing 210.

The operation of the control device 200 is similar to the operation of the control device 1B, so the description thereof is omitted. In addition, the control device 200 according to the present embodiment has similar advantageous effects to the advantageous effects (1) to (4) of the motor unit 1 according to the first embodiment.

### Third Embodiment

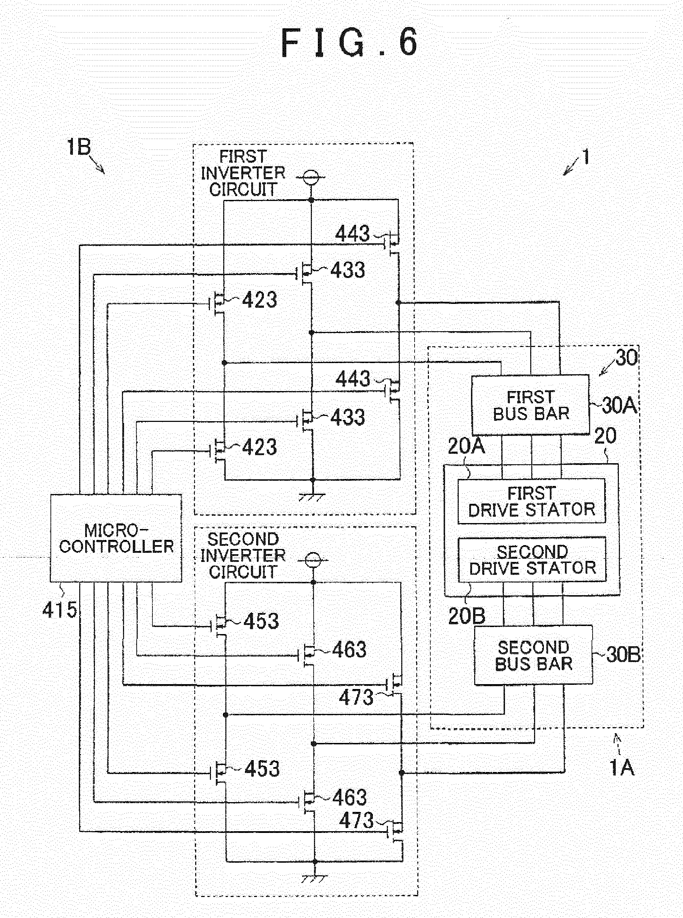

FIG. 6 to FIG. 9 show the motor unit 1 according to the third embodiment. The motor unit 1 according to the present embodiment differs from the motor unit 1 according to the first embodiment in the circuit configuration of the electric motor 1A, the circuit configuration of the control device 1B, the configuration of part of the housing 60, the configuration of a heat sink 300 and the configuration of a circuit board 400. Hereinafter, the details of the difference from the motor unit 1 according to the first embodiment will be described, like reference numerals denote components common to the first embodiment, and part or all of the description is omitted.

The circuit configuration of the electric motor 1A and the circuit configuration of the control device 1B will be described with reference to FIG. 6. The control device 1B includes two inverter circuits and a microcontroller 415. The two inverter circuits are used to drive the electric motor 1A in two systems. The microcontroller 415 controls the operations of the inverter circuits. The control device 1B includes an internal connector 413 and an external connector 414. The internal connector 413 is electrically connected to the bus bar 30 and the resolver 50. The external connector 414 is electrically connected to a device outside the motor unit 1.

The control device 1B includes the first inverter circuit and the second inverter circuit for driving the electric motor 1A. The first inverter circuit has two first U-phase power elements 423 serving as switching elements, two first V-phase power elements 433 serving as switching elements, and two first W-phase power elements 443 serving as switching elements. The first U-phase power elements 423 are connected in series with each other. The first V-phase power elements 433 are connected in series with each other. The first W-phase power elements 443 are connected in series with each other. The first U-phase power elements 423, the first V-phase power elements 433 and the first W-phase power elements 443 are connected in parallel with one another.

The second inverter circuit has two second U-phase power elements 453 serving as switching elements, two second V-phase power elements 463 serving as switching elements, and two second W-phase power elements 473 serving as switching elements. The second U-phase power elements 453 are connected in series with each other. The second V-phase power elements 463 are connected in series with each other. The second W-phase power elements 473 are connected in series with each other. The second U-phase power elements 453, the second V-phase power elements 463 and the second W-phase power elements 473 are connected in parallel with one another. For example, MOSFETs are used as the phase power elements 423 to 473.

The microcontroller 415 controls switching between a conductive state and a nonconductive state of each of the phase power elements 423 to 473. The stator 20 of the electric motor 1A includes a first drive stator 20A and a second drive stator 208. The stator 20 is split into the first drive stator 20A and the second drive stator 20B in the circumferential direction ZC. Supply of electric power to the first drive stator 20A is controlled by the first inverter circuit. Supply of electric power to the second drive stator 20B is controlled by the second inverter circuit.

The bus bar 30 of the electric motor 1A includes a first bus bar 30A and a second bus bar 30B. The first bus bar 30A electrically connects the first inverter circuit and the first drive stator 20A to each other. The second bus bar 30B electrically connects the second inverter circuit and the second drive stator 20B to each other. The bus bar 30 is split into the first bus bar 30A and the second bus bar 30B in the circumferential direction ZC. The first bus bar 30A is arranged at the same location as the first drive stator 20A in the circumferential direction ZC. The second bus bar 30B is arranged at the same location as the second drive stator 20B in the circumferential direction ZC.

The control device 1B executes drive control over the electric motor 1A with the use of the first inverter circuit during normal times. The control device 1B executes drive control over the electric motor 1A with the use of the second inverter circuit when the first inverter circuit fails.

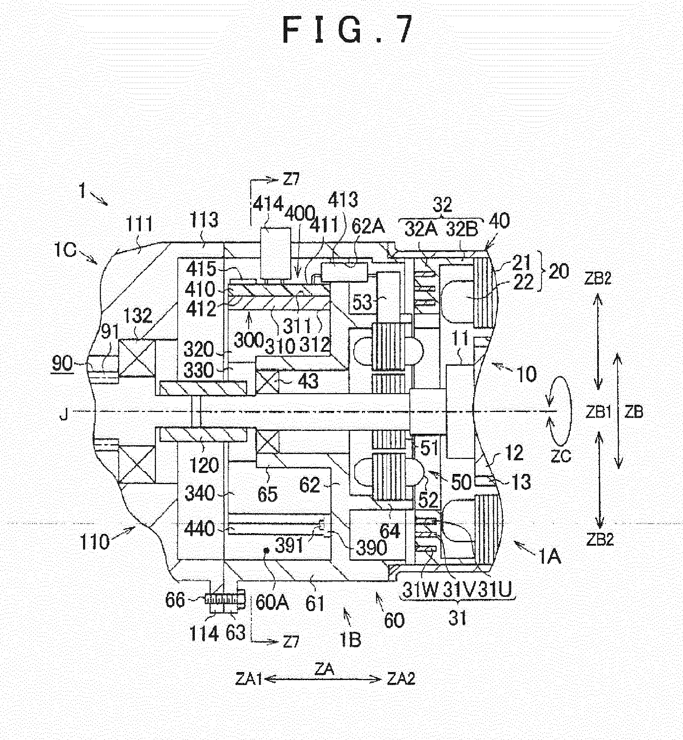

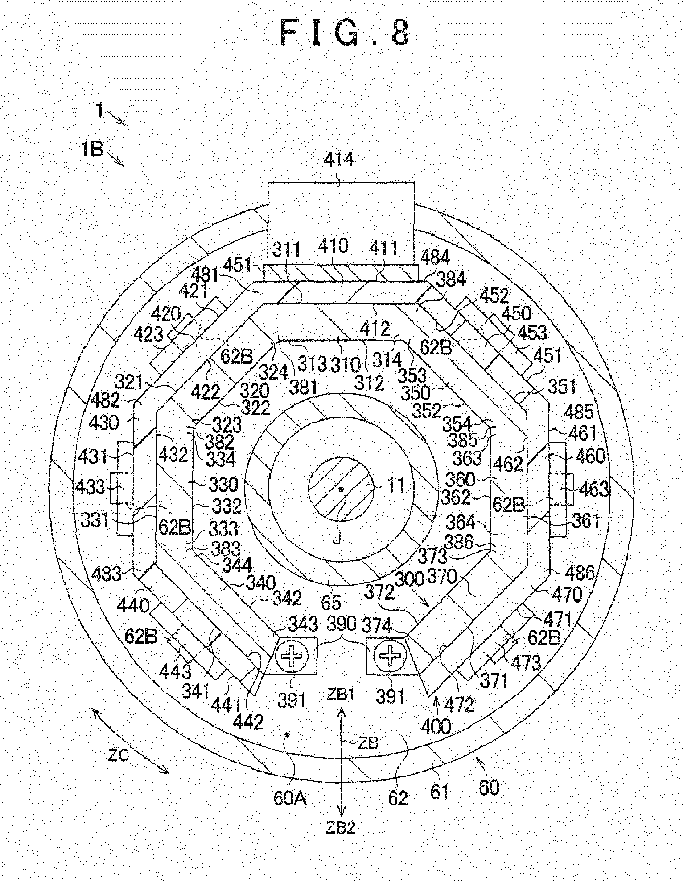

As shown in FIG. 7, the bottom wall 62 of the housing 60 has an open hole 62A at a location at which the open hole 62A overlaps with the circuit connection member 53 of the resolver 50 in the axial direction ZA. The open hole 62A extends through the bottom wall 62 in the axial direction ZA. The bottom wall 62 of the housing 60 has six through-holes 62B for inserting the phase copper plates 31U, 31V, 31W of the bus bar 30 (see FIG. 8).

The heat sink 300 is formed of aluminum. The heat sink 300 has a shape in which one side of an octagonal shape is cut out in plan view (see FIG. 8). The heat sink 300 is accommodated in the housing 60. The heat sink 300 is fixed to the bottom wall 62 of the housing 60. The heat sink 300 is upright in the distal end direction ZA1 from the bottom wall 62. The heat sink 300 surrounds the output shaft 11 and the bearing support portion 65 from a side in the outward direction ZB2 via a space.

As shown in FIG. 8, the heat sink 300 has seven heat dissipation wall portions in which heat of the circuit board 400 is transferred, that is, a first heat dissipation wall portion 310, a second heat dissipation wall portion 320, a third heat dissipation wall portion 330, a fourth heat dissipation wall portion 340, a fifth heat dissipation wall portion 350, a sixth heat dissipation wall portion 360 and a seventh heat dissipation wall portion 370. The heat sink 300 has six coupling wall portions that couple the heat dissipation wall portions 310 to 370, that is, a first coupling wall portion 381, a second coupling wall portion 382, a third coupling wall portion 383, a fourth coupling wall portion 384, a fifth coupling wall portion 385 and a sixth coupling wall portion 386. The heat sink 300 has two fixing portions 390 for fixing the heat sink 300 to the bottom wall 62. The heat sink 300 has such a structure that the heat dissipation wall portions 310 to 370, the coupling wall portions 381 to 386 and the fixing portions 390 are integrally molded from the same material.

In the heat sink 300, the second heat dissipation wall portion 320 to the fourth heat dissipation wall portion 340 and the fifth heat dissipation wall portion 350 to the seventh heat dissipation wall portion 370 are located on opposite sides of the first heat dissipation wall portion 310 in the circumferential direction ZC. The second heat dissipation wall portion 320 to the fourth heat dissipation wall portion 340 are arranged at the same location in the circumferential direction ZC as the first drive stator 20A and first bus bar 30A (see FIG. 6) of the electric motor 1A. The fifth heat dissipation wall portion 350 to the seventh heat dissipation wall portion 370 are arranged at the same location in the circumferential direction ZC as the second drive stator 20B and second bus bar 30B (see FIG. 6) of the electric motor 1A.

The circuit board 400 is fixed to the heat sink 300. The circuit board 400 is formed as a multilayer printed circuit board in which a plurality of thermoplastic films are laminated. The circuit board 400 has through-holes and inter-layer connecting portions (not shown) formed of electrically conductive paste filled in the through-holes. The circuit board 400 is formed by thermo-compression bonding in a state where the thermoplastic films having conductor patterns and electrically conductive paste are laminated.

The circuit board 400 includes seven board portions on which electronic components are mounted, that is, a first board portion 410, a second board portion 420, a third board portion 430, a fourth board portion 440, a fifth board portion 450, a sixth board portion 460 and a seventh board portion 470. The circuit board 400 includes six coupling portions that couple the board portions 410 to 470 to each other, that is, a first coupling portion 481, a second coupling portion 482, a third coupling portion 483, a fourth coupling portion 484, a fifth coupling portion 485 and a sixth coupling portion 486. The circuit board 400 has such a structure that the board portions 410 to 470 and the coupling portions 481 to 486 are integrally molded.

In the circuit board 400, the second board portion 420 to the fourth board portion 440 and the fifth board portion 450 to the seventh board portion 470 are located on opposite sides of the first board portion 410 in the circumferential direction ZC. The second board portion 420 to fourth board portion 440 are arranged at the same location in the circumferential direction ZC as the first drive stator 20A and first bus bar 30A of the electric motor 1A. The second board portion 420 to fourth board portion 440 are arranged at a location at which the second board portion 420 to fourth board portion 440 overlap with the first drive stator 20A in the radial direction ZB. The fifth board portion 450 to the seventh board portion 470 are arranged at the same location in the circumferential direction ZC as the second drive stator 20B and second bus bar 30B of the electric motor 1A. The fifth board portion 450 to the seventh board portion 470 are arranged at a location at which the fifth board portion 450 to the seventh board portion 470 overlap with the second drive stator 20B in the radial direction ZB.

The detailed configuration of the heat sink 300 will be described with reference to FIG. 8. The heat dissipation wall portions 310 to 370 each have a rectangular shape. The heat dissipation wall portions 310 to 370 each extend in the axial direction ZA from the bottom wall 62. In the present embodiment, the volumes of the heat dissipation wall portions 310 to 370 are equal to one another.

The first heat dissipation wall portion 310 is formed at a location between the second heat dissipation wall portion 320 and the fifth heat dissipation wall portion 350. The first heat dissipation wall portion 310 has a first heat dissipation principal surface 311, a first heat dissipation back surface 312, a first one end portion 313 and a first other end portion 314. The first heat dissipation principal surface 311 forms the outer surface of the first heat dissipation wall portion 310. The first heat dissipation back surface 312 forms the inner surface of the first heat dissipation wall portion 310. The first one end portion 313 is formed in the first heat dissipation wall portion 310 at a location close to the second heat dissipation wall portion 320. The first other end portion 314 is formed in the first heat dissipation wall portion 310 at a location close to the fifth heat dissipation wall portion 350.

The second heat dissipation wall portion 320 is formed at a location between the first heat dissipation wall portion 310 and the third heat dissipation wall portion 330. The second heat dissipation wall portion 320 has a second heat dissipation principal surface 321, a second heat dissipation back surface 322, a second one end portion 323 and a second other end portion 324. The second heat dissipation principal surface 321 forms the outer surface of the second heat dissipation wall portion 320. The second heat dissipation back surface 322 forms the inner surface of the second heat dissipation wall portion 320. The second one end portion 323 is formed in the second heat dissipation wall portion 320 at a location close to the third heat dissipation wall portion 330. The second other end portion 324 is formed in the second heat dissipation wall portion 320 at a location close to the first heat dissipation wall portion 310.

The third heat dissipation wall portion 330 is formed at a location between the second heat dissipation wall portion 320 and the fourth heat dissipation wall portion 340. The third heat dissipation wall portion 330 has a third heat dissipation principal surface 331, a third heat dissipation back surface 332, a third one end portion 333 and a third other end portion 334. The third heat dissipation principal surface 331 forms the outer surface of the third heat dissipation wall portion 330. The third heat dissipation back surface 332 forms the inner surface of the third heat dissipation wall portion 330. The third one end portion 333 is formed in the third heat dissipation wall portion 330 at a location close to the fourth heat dissipation wall portion 340. The third other end portion 334 is formed in the third heat dissipation wall portion 330 at a location close to the second heat dissipation wall portion 320.

The fourth heat dissipation wall portion 340 is formed at a location between the third heat dissipation wall portion 330 and one of the fixing portions 390. The fourth heat dissipation wall portion 340 has a fourth heat dissipation principal surface 341, a fourth heat dissipation back surface 342, a fourth one end portion 343 and a fourth other end portion 344. The fourth heat dissipation principal surface 341 forms the outer surface of the fourth heat dissipation wall portion 340. The fourth heat dissipation back surface 342 forms the inner surface of the fourth heat dissipation wall portion 340. The fourth one end portion 343 is formed in the fourth heat dissipation wall portion 340 at a location close to the one of the fixing portions 390. The fourth other end portion 344 is formed in the fourth heat dissipation wall portion 340 at a location close to the third heat dissipation wall portion 330.

The fifth heat dissipation wall portion 350 is formed at a location between the first heat dissipation wall portion 310 and the sixth heat dissipation wall portion 360. The fifth heat dissipation wall portion 350 has a fifth heat dissipation principal surface 351, a fifth heat dissipation back surface 352, a fifth one end portion 353 and a fifth other end portion 354. The fifth heat dissipation principal surface 351 forms the outer surface of the fifth heat dissipation wall portion 350. The fifth heat dissipation back surface 352 forms the inner surface of the fifth heat dissipation wall portion 350. The fifth one end portion 353 is formed in the fifth heat dissipation wall portion 350 at a location close to the first heat dissipation wall portion 310. The fifth other end portion 354 is formed in the fifth heat dissipation wall portion 350 at a location close to the sixth heat dissipation wall portion 360.

The sixth heat dissipation wall portion 360 is formed at a location between the fifth heat dissipation wall portion 350 and the seventh heat dissipation wall portion 370. The sixth heat dissipation wall portion 360 has a sixth heat dissipation principal surface 361, a sixth heat dissipation back surface 362, a sixth one end portion 363 and a sixth other end portion 364. The sixth heat dissipation principal surface 361 forms the outer surface of the sixth heat dissipation wall portion 360. The sixth heat dissipation back surface 362 forms the inner surface of the sixth heat dissipation wall portion 360. The sixth one end portion 363 is formed in the sixth heat dissipation wall portion 360 at a location close to the fifth heat dissipation wall portion 350. The sixth other end portion 364 is formed in the sixth heat dissipation wall portion 360 at a location close to the seventh heat dissipation wall portion 370.

The seventh heat dissipation wall portion 370 is formed at a location between the sixth heat dissipation wall portion 360 and the other one of the fixing portions 390. The seventh heat dissipation wall portion 370 has a seventh heat dissipation principal surface 371, a seventh heat dissipation back surface 372, a seventh one end portion 373 and a seventh other end portion 374. The seventh heat dissipation principal surface 371 forms the outer surface of the seventh heat dissipation wall portion 370. The seventh heat dissipation back surface 372 forms the inner surface of the seventh heat dissipation wall portion 370. The seventh one end portion 373 is formed in the seventh heat dissipation wall portion 370 at a location close to the sixth heat dissipation wall portion 360. The seventh other end portion 374 is formed in the seventh heat dissipation wall portion 370 at a location close to the other one of the fixing portions 390.

The first coupling wall portion 381 is located between the first one end portion 313 and the second other end portion 324. The first coupling wall portion 381 couples the first one end portion 313 and the second other end portion 324 to each other. The first coupling wall portion 381 bends in a direction in which the first heat dissipation back surface 312 and the second heat dissipation back surface 322 face each other.

The second coupling wall portion 382 is located between the second one end portion 323 and the third other end portion 334. The second coupling wall portion 382 couples the second one end portion 323 and the third other end portion 334 to each other. The second coupling wall portion 382 bends in a direction in which the second heat dissipation back surface 322 and the third heat dissipation back surface 332 face each other.

The third coupling wall portion 383 is located between the third one end portion 333 and the fourth other end portion 344. The third coupling wall portion 383 couples the third one end portion 333 and the fourth other end portion 344 to each other. The third coupling wall portion 383 bends in a direction in which the third heat dissipation back surface 332 and the fourth heat dissipation back surface 342 face each other.

The fourth coupling wall portion 384 is located between the first other end portion 314 and the fifth one end portion 353. The fourth coupling wall portion 384 couples the first other end portion 314 and the fifth one end portion 353 to each other. The fourth coupling wall portion 384 bends in a direction in which the first heat dissipation back surface 312 and the fifth heat dissipation back surface 352 face each other.

The fifth coupling wall portion 385 is located between the fifth other end portion 354 and the sixth one end portion 363. The fifth coupling wall portion 385 couples the fifth other end portion 354 and the sixth one end portion 363 to each other. The fifth coupling wall portion 385 bends in a direction in which the fifth heat dissipation back surface 352 and the sixth heat dissipation back surface 362 face each other.

The sixth coupling wall portion 386 is located between the sixth other end portion 364 and the seventh one end portion 373. The sixth coupling wall portion 386 couples the sixth other end portion 364 and the seventh one end portion 373 to each other. The sixth coupling wall portion 386 bends in a direction in which the sixth heat dissipation back surface 362 and the seventh heat dissipation back surface 372 face each other.

The fixing portions 390 each have a rectangular shape. The fixing portions 390 respectively protrude from the end portion of the fourth one end portion 343 in the proximal end direction ZA2 and the end portion of the seventh other end portion 374 in the proximal end direction ZA2. Each of the fixing portions 390 is fixed to the bottom wall 62 by a bolt 391.

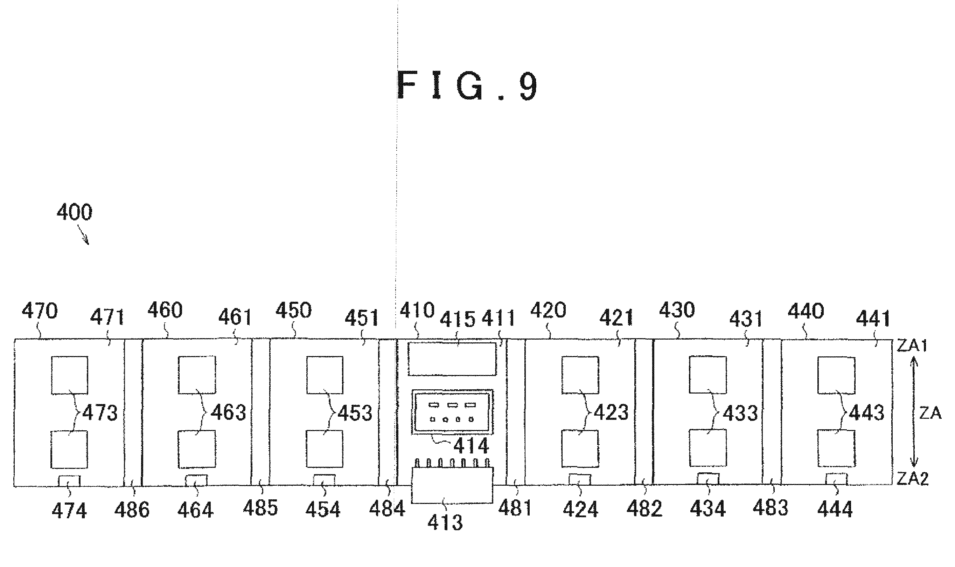

The detailed configuration of the circuit board 400 will be described with reference to FIG. 8 and FIG. 9. The board portions 410 to 470 each have a rectangular shape. The board portions 410 to 470 extend in the axial direction ZA.

The first board portion 410 has a first principal surface 411 and a first back surface 412. The first back surface 412 of the first board portion 410 is fixed to the first heat dissipation principal surface 311 of the first heat dissipation wall portion 310.

The second board portion 420 has a second principal surface 421 and a second back surface 422. The second back surface 422 of the second board portion 420 is fixed to the second heat dissipation principal surface 321 of the second heat dissipation wall portion 320. In the second board portion 420, a bus bar connection portion 424 is formed at the end portion of the second principal surface 421 in the proximal end direction ZA2. The bus bar connection portion 424 of the second board portion 420 is connected to the U-phase copper plate 31U (see FIG. 7) for connection with the first inverter circuit.

The third board portion 430 has a third principal surface 431 and a third back surface 432. The third back surface 432 of the third board portion 430 is fixed to the third heat dissipation principal surface 331 of the third heat dissipation wall portion 330. In the third board portion 430, a bus bar connection portion 434 is formed at the end portion of the third principal surface 431 in the proximal end direction ZA2. The bus bar connection portion 434 of the third board portion 430 is connected to the V-phase copper plate 31V (see FIG. 7) for connection with the first inverter circuit.

The fourth board portion 440 has a fourth principal surface 441 and a fourth back surface 442. The fourth back surface 442 of the fourth board portion 440 is fixed to the fourth heat dissipation principal surface 341 of the fourth heat dissipation wall portion 340. In the fourth board portion 440, a bus bar connection portion 444 is formed at the end portion of the fourth principal surface 441 in the proximal end direction ZA2, The bus bar connection portion 444 of the fourth board portion 440 is connected to the W-phase copper plate 31W (see FIG. 7) for connection with the first inverter circuit.

The fifth board portion 450 has a fifth principal surface 451 and a fifth back surface 452. The fifth back surface 452 of the fifth board portion 450 is fixed to the fifth heat dissipation principal surface 351 of the fifth heat dissipation wall portion 350. In the fifth board portion 450, a bus bar connection portion 454 is formed at the end portion of the fifth principal surface 451 in the proximal end direction ZA2. The bus bar connection portion 454 of the fifth board portion 450 is connected to the U-phase copper plate 31U (see FIG. 7) for connection with the second inverter circuit.

The sixth board portion 460 has a sixth principal surface 461 and a sixth back surface 462. The sixth back surface 462 of the sixth board portion 460 is fixed to the sixth heat dissipation principal surface 361 of the sixth heat dissipation wall portion 360. In the sixth board portion 460, a bus bar connection portion 464 is formed at the end portion of the sixth principal surface 461 in the proximal end direction ZA2. The bus bar connection portion 464 of the sixth board portion 460 is connected to the V-phase copper plate 31V (see FIG. 7) for connection with the second inverter circuit.

The seventh board portion 470 has a seventh principal surface 471 and a seventh back surface 472. The seventh back surface 472 of the seventh board portion 470 is fixed to the seventh heat dissipation principal surface 371 of the seventh heat dissipation wall portion 370. In the seventh board portion 470, a bus bar connection portion 474 is formed at the end portion of the seventh principal surface 471 in the proximal end direction ZA2. The bus bar connection portion 474 of the seventh board portion 470 is connected to the W-phase copper plate 31W (see FIG. 7) for connection with the second inverter circuit.

The first coupling portion 481 is formed at a location between the first board portion 410 and the second board portion 420. The first coupling portion 481 couples the first board portion 410 and the second board portion 420 to each other. The first coupling portion 481 bends in a direction in which the first back surface 412 and the second back surface 422 face each other.

The second coupling portion 482 is formed at a location between the second board portion 420 and the third board portion 430. The second coupling portion 482 couples the second board portion 420 and the third board portion 430 to each other. The second coupling portion 482 bends in a direction in which the second back surface 422 and the third back surface 432 face each other.

The third coupling portion 483 is formed at a location between the third board portion 430 and the fourth board portion 440. The third coupling portion 483 couples the third board portion 430 and the fourth board portion 440 to each other. The third coupling portion 483 bends in a direction in which the third back surface 432 and the fourth back surface 442 face each other.

The fourth coupling portion 484 is formed at a location between the first board portion 410 and the fifth board portion 450. The fourth coupling portion 484 couples the first board portion 410 and the fifth board portion 450 to each other. The fourth coupling portion 484 bends in a direction in which the first back surface 412 and the fifth back surface 452 face each other.

The fifth coupling portion 485 is formed at a location between the fifth board portion 450 and the sixth board portion 460. The fifth coupling portion 485 couples the fifth board portion 450 and the sixth board portion 460 to each other. The fifth coupling portion 485 bends in a direction in which the fifth back surface 452 and the sixth back surface 462 face each other.

The sixth coupling portion 486 is formed at a location between the sixth board portion 460 and the seventh board portion 470. The sixth coupling portion 486 couples the sixth board portion 460 and the seventh board portion 470 to each other. The sixth coupling portion 486 bends in a direction in which the sixth back surface 462 and the seventh back surface 472 face each other.

A structure of mounting electronic components on the circuit board 400 will be described with reference to FIG. 9, In the circuit board 400, the internal connector 413 and the external connector 414 that serve as electronic components and the microcontroller 415 that serves as a control element are mounted. In the circuit board 400, the first U-phase power elements 423, the first V-phase power elements 433, the first W-phase power elements 443, the second U-phase power elements 453, the second V-phase power elements 463 and the second W-phase power elements 473 are mounted as electronic components. The internal connector 413 and the external connector 414 correspond to "connector".

The internal connector 413, the external connector 414 and the microcontroller 415 are mounted on the first principal surface 411 of the first board portion 410. The internal connector 413 is electrically connected to the terminal pins of the circuit connection member 53 of the resolver 50 (see FIG. 7). The external connector 414 is electrically connected to the phase power elements 423 to 473.

The first U-phase power elements 423 are mounted on the second principal surface 421 of the second board portion 420. The first U-phase power elements 423 are aligned in the axial direction ZA. The first V-phase power elements 433 are mounted on the third principal surface 431 of the third board portion 430. The first V-phase power elements 433 are aligned in the axial direction ZA. The first W-phase power elements 443 are mounted on the fourth principal surface 441 of the fourth board portion 440. The first W-phase power elements 443 are aligned in the axial direction ZA.

The second U-phase power elements 453 are mounted on the fifth principal surface 451 of the fifth board portion 450. The second U-phase power elements 453 are aligned in the axial direction ZA. The second V-phase power elements 463 are mounted on the sixth principal surface 461 of the sixth board portion 460. The second V-phase power elements 463 are aligned in the axial direction ZA. The second W-phase power elements 473 are mounted on the seventh principal surface 471 of the seventh board portion 470. The second W-phase power elements 473 are aligned in the axial direction ZA.

The operation of the motor unit 1 according to the present embodiment will be described. The motor unit 1 has first and second functions. The first function is the function of suppressing an excessive rise in the temperature of a portion of the phase power elements 423 to 443. The second function is the function of reducing variations in connection distance between each inverter circuit and the electric motor 1A.

The details of the first function will be described. The phase power elements 423 to 473 of the inverter circuits are respectively mounted on the board portions 410 to 470 of the circuit board 400 phase by phase. Therefore, the two power elements are mounted on each of the board portions 410 to 470. Therefore, when the first inverter circuit is driven, heat generated in each of the phase power elements 423 to 443 is transferred to a corresponding one of the first heat dissipation wall portion 310 to third heat dissipation wall portion 330 of the heat sink 300 via a corresponding one of the first board portion 410 to the third board portion 430. Thus, heat of each of the phase power elements 423 to 443 is equally dissipated, so an excessive rise in the temperature of only a portion of the phase power elements 423 to 443 is suppressed. This also applies to the relationship among the phase power elements 453 to 473, the fifth board portion 450 to the seventh board portion 470 and the fifth heat dissipation wall portion 350 to the seventh heat dissipation wall portion 370, so the description thereof is omitted.

The details of the second function will be described. The second board portion 420 to the fourth board portion 440 are arranged at the same location in the circumferential direction ZC as the first drive stator 20A and first bus bar 30A of the electric motor 1A. Thus, the length of the U-phase copper plate 31U that connects the second board portion 420 to the U-phase stator of the first drive stator 20A, the length of the V-phase copper plate 31V that connects the third board portion 430 to the V-phase stator of the first drive stator 20A and the length of the W-phase copper plate 31W that connects the fourth board portion 440 to the W-phase stator of the first drive stator 20A are equal to one another. Therefore, in comparison with a configuration that it is assumed that the second board portion 420 to the fourth board portion 440 are arranged at a different position in the circumferential direction ZC from the first drive stator 20A and the first bus bar 30A, variations in connection distance between the first inverter circuit and the first drive stator 20A of the electric motor 1A reduce. This also applies to the relationship among the fifth board portion 450 to the seventh board portion 470, the second drive stator 20B and the second bus bar 30B, so the description thereof is omitted.

The motor unit 1 according to the present embodiment has the following advantageous effects in addition to the advantageous effects (1), (2) and (4) of the motor unit 1 according to the first embodiment. (5) In the motor unit 1, the phase power elements 423 to 473 of the inverter circuits are mounted on the board portions 420 to 470 of the circuit board 400 phase by phase. With this configuration, heat of each of the phase power elements 423 to 443 is equally dissipated, so an excessive rise in the temperature of only a portion of the phase power elements 423 to 443 is suppressed.

(6) In the motor unit 1, the second board portion 420 to the fourth board portion 440 are arranged at the same location in the circumferential direction ZC as the first drive stator 20A of the electric motor 1A. With this configuration, in comparison with a configuration that it is assumed that the second board portion 420 to the fourth board portion 440 are arranged at a different position in the circumferential direction ZC from the first drive stator 20A, variations in connection distance between the first inverter circuit and the first drive stator 20A and first bus bar 30A of the electric motor 1A reduce. This also applies to the relationship between the fifth board portion 450 to the seventh board portion 470 and the second drive stator 20B.

### Other Embodiments

The invention includes embodiments other than the first to third embodiments. Hereinafter, alternative embodiments to the first to third embodiments will be described as other embodiments of the invention. The following alternative embodiments may be combined with each other.

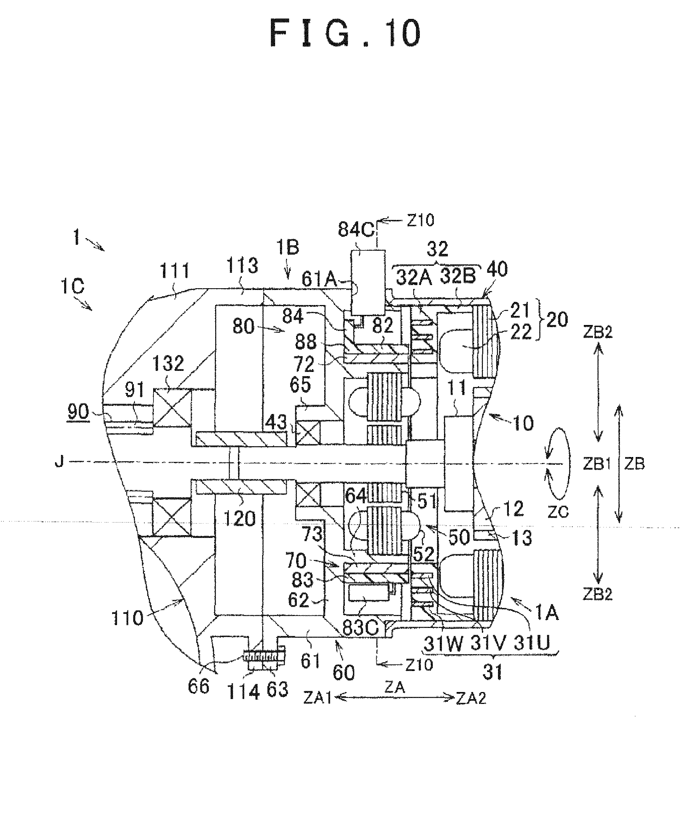

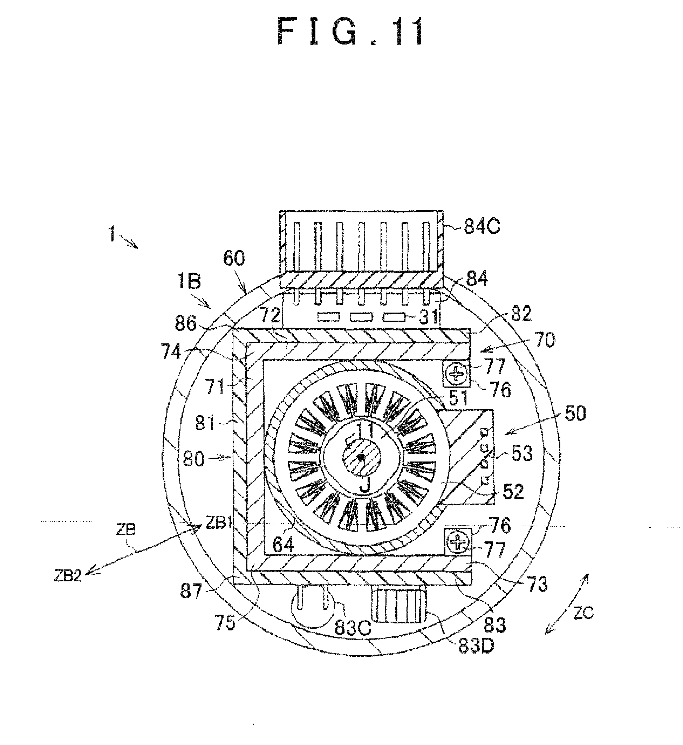

In the control device 1B according to the first embodiment, the heat sink 70 and the circuit board 80 are located in the distal end direction ZA1 with respect to the resolver 50. In contrast, as shown in FIG. 10, in the motor unit 1 according to an alternative embodiment, the heat sink 70 and the circuit board 80 overlap with the resolver 50 in the axial direction ZA. The heat sink 70 and the circuit board 80 are fixed to the surface of the bottom wall 62 at the side in the proximal end direction ZA2. As shown in FIG. 11, the heat sink 70 and the circuit board 80 surround a portion other than a portion at which the circuit connection member 53 of the resolver 50 is arranged. The circuit connection member 53 is electrically connected to the second board portion 82 by leads (not shown). The copper plates 31 of the bus bar 30 are electrically connected to the fourth board portion 84. In the circuit board 80 according to the alternative embodiment, the second board portion 82 and the fourth board portion 84 are coupled to each other by the third coupling portion 88 (see FIG. 10), and the fifth board portion 85 and the fourth coupling portion 89 are omitted.

With this configuration, it is possible to reduce the size of the side wall 61 of the housing 60 in the axial direction ZA, so it is possible to reduce the size of the motor unit 1 in the axial direction ZA as compared to the motor unit 1 according to the first embodiment.

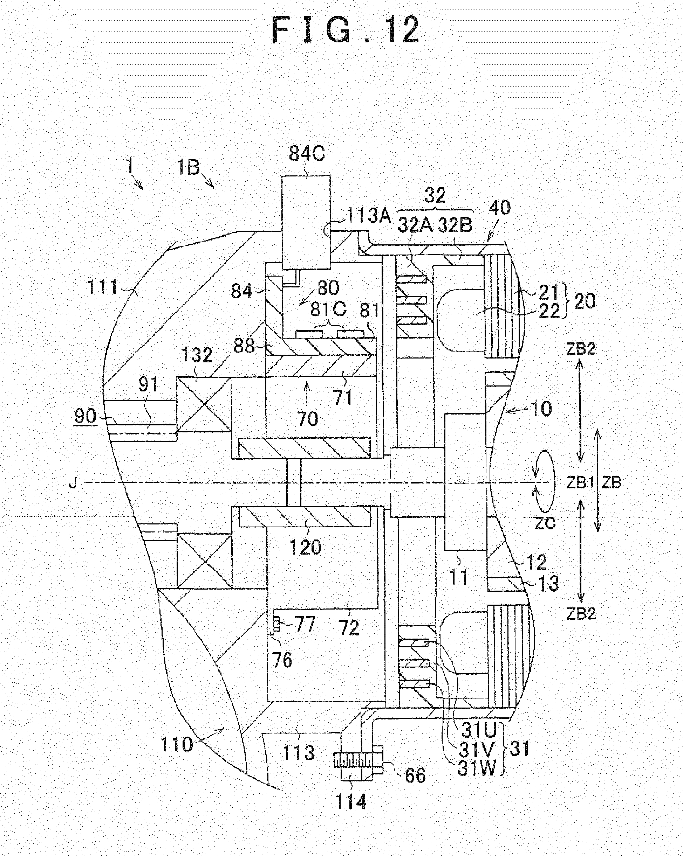

In the motor unit 1 according to the first embodiment, the heat sink 70 and the circuit board 80 are fixed to the bottom wall 62 of the housing 60. In contrast, as shown in FIG. 12, in the motor unit 1 according to an alternative embodiment, the heat sink 70 and the circuit board 80 are fixed to the gear housing 110. In the motor unit 1 according to the alternative embodiment, the gear housing 110 is fixed to the motor housing 40 by the bolts 66. That is, the motor unit 1 according to the alternative embodiment has neither the housing 60 nor the ball bearing 43. The motor unit 1 according to the alternative embodiment is configured as a sensorless motor instead of the resolver 50. The motor unit 1 according to the alternative embodiment has the gear housing 110 in which the connector insertion portion 113A is formed in the side wall 113. The external connector 84C is inserted in the connector insertion portion 113A. The motor unit 1 according to the alternative embodiment may have such a structure that the gear housing 110 and the heat sink 70 are integrally molded from the same metal material. In the motor unit 1 according to the alternative embodiment, the gear housing 110 corresponds to "housing".

With this configuration, it is possible to reduce the size of the motor unit 1 in the axial direction ZA. Because the housing 60 is omitted, it is possible to reduce the number of components that constitute the motor unit 1.

The control device 1B according to the first embodiment includes the heat sink 70 in which the first heat dissipation wall portion 71, the second heat dissipation wall portion 72 and the third heat dissipation wall portion 73 are coupled to each other by the first coupling wall portion 74 and the second coupling wall portion 75. In contrast, the control device 1B according to an alternative embodiment includes the heat sink 70 in which at least one of the first coupling wall portion 74 and the second coupling wall portion 75 is omitted. A similar modification may be added to the control device 200 according to the second embodiment.

The control device 1B according to the above-described alternative embodiment may have the circuit board 80 in which at least one of the first coupling portion 86 and the second coupling portion 87 is omitted. A similar modification may be added to the control device 200 according to the second embodiment.

The heat sink 70 according to the first embodiment includes the first heat dissipation wall portion 71, the second heat dissipation wall portion 72 and the third heat dissipation wall portion 73. In contrast, in the heat sink 70 according to an alternative embodiment, at least one of the second heat dissipation wall portion 72 and the third heat dissipation wall portion 73 is omitted. In the circuit board 80 according to the alternative embodiment, in correspondence with omission of at least one of the second heat dissipation wall portion 72 and the third heat dissipation wall portion 73, at least one of the corresponding second board portion 82 and the corresponding third board portion 83 is omitted. A similar modification may be added to the control device 200 according to the second embodiment.

The heat sink 70 according to another alternative embodiment includes a fourth heat dissipation wall portion, a fourth coupling wall portion and a fifth coupling wall portion. The fourth heat dissipation wall portion is located between the second other end portion 72Y of the second heat dissipation wall portion 72 and the third other end portion 73Y of the third heat dissipation wall portion 73, and faces the bearing support portion 65. The fourth heat dissipation wall portion has a fourth one end portion adjacent to the second other end portion 72Y and a fourth other end portion adjacent to the third other end portion 73Y. The fourth coupling wall portion couples the second other end portion 72Y and the fourth one end portion to each other. The fifth coupling wall portion couples the third other end portion 73Y and the fourth other end portion to each other. The circuit board 80 may include a sixth board portion that is connected to the fourth heat dissipation wall portion. The sixth board portion is connected to the end portion of the second board portion 82 across from the first coupling portion 86. A fifth coupling portion is formed between the sixth board portion and the second board portion 82. The sixth board portion may be connected to the end portion of the third board portion 83 across from the second coupling portion 87. In this case, the fifth coupling portion is formed between the sixth board portion and the third board portion. A similar modification may be added to the control device 200 according to the second embodiment.

The control device 1B according to the first embodiment has such a structure that the heat sink 70 and the housing 60 are individually formed. In contrast, the control device 1B according to an alternative embodiment has such a structure that the heat sink 70 and the housing 60 are integrally molded from the same metal material. In the heat sink 70 according to the alternative embodiment, the fixing portions 76 and the bolts 77 are omitted. A similar modification may be added to the control device 200 according to the second embodiment.

In the control device 1B according to the above-described alternative embodiment, the heat sink 70 and the bearing support portion 65 may be integrally molded. That is, the heat sink 70 also has the function of the bearing support portion 65. In addition, in the control devices 1B according to the alternative embodiments shown in FIG. 10 and FIG. 12, the heat sink 70 and the resolver support portion 64 may be integrally molded. That is, the heat sink 70 also has the function of the resolver support portion 64.

The control device 1B according to the first embodiment has the circuit board 80 that is formed as a multilayer printed circuit board in which a plurality of thermoplastic resin films are laminated. In contrast, the control device 1B according to an alternative embodiment has the circuit board 80 in which the first board portion 81 to the fifth board portion 85 are formed as printed circuit boards having thermoplastic resin as a base material and the first coupling portion 86 to the fourth coupling portion 89 are formed as flexible printed circuit boards. A similar modification may be added to the control device 200 according to the second embodiment. A similar modification may be added to the circuit board 400 of the control device 1B according to the third embodiment.

The control device 1B according to the first embodiment includes the circuit board 80 in which the number of thermoplastic resin films laminated in each of the first board portion 81 to the fifth board portion 85 is equal to the number of thermoplastic resin films laminated in each of the first coupling portion 86 to the fourth coupling portion 89. In contrast, the control device 1B according to an alternative embodiment includes the circuit board 80 in which the number of thermoplastic resin films laminated in each of the first coupling portion 86 to the fourth coupling portion 89 is smaller than the number of thermoplastic resin films laminated in each of the first board portion 81 to the fifth board portion 85. A similar modification may be added to the control device 200 according to the second embodiment. A similar modification may be added to the circuit board 400 of the control device 1B according to the third embodiment.

The control device 1B according to the first embodiment includes the circuit board 80 in which the first board portion 81, the second board portion 82 and the third board portion 83 are connected to each other by the first coupling portion 86 and the second coupling portion 87. In contrast, the control device 1B according to an alternative embodiment includes the circuit board 80 in which the first coupling portion 86 and the second coupling portion 87 are omitted. That is, in the control device 1B according to the alternative embodiment, the board portions 81 to 83 are spaced apart from each other. A similar modification may be added to the control device 200 according to the second embodiment. A similar modification may be added to the circuit board 400 of the control device 1B according to the third embodiment.

The control device 1B according to the first embodiment includes the circuit board 80 in which the power elements 81C are mounted on the first board portion 81 and the power elements 82C are mounted on the second board portion 82. In contrast, the control device 1B according to an alternative embodiment includes the circuit board 80 in which the power elements 81C, 82C are mounted on the first board portion 81. That is, the control device 1B according to the alternative embodiment includes the circuit board 80 in which the power elements 82C are omitted from the second board portion 82.

The motor unit 1 according to the third embodiment includes the separately formed internal connector 413 and external connector 414. In contrast, the motor unit 1 according to an alternative embodiment includes a power supply module in which the internal connector 413 and the external connector 414 are integrally molded. The microcontroller 415 and another control element are mounted on the power supply module.

The circuit board 400 according to the third embodiment has an I shape in developed plan view. In contrast, the circuit board 400 according to an alternative embodiment has a T shape in developed plan view. The heat sink 300 according to the third embodiment surrounds the bearing support portion 65 of the housing 60 via a space. In contrast, the heat sink 300 according to an alternative embodiment surrounds the bearing support portion 65 in a state where the heat sink 300 is in contact with the outer periphery of the bearing support portion 65 of the housing 60.

The motor unit 1 according to the third embodiment is configured to drive the electric motor 1A in two systems. In contrast, the motor unit 1 according to an alternative embodiment is configured to drive the electric motor 1A in three or more systems.

The control device 1B according to the third embodiment is integrally formed with the electric motor 1A. In contrast, the control device 1B according to an alternative embodiment is separately formed from the electric motor 1A. In the control device 1B according to the alternative embodiment, as in the case of the control device 200 according to the second embodiment, the housing 210 and the cover 220 accommodate the circuit board 400 and the heat sink 300.

The electric motor 1A according to the first and third embodiments includes the resolver 50 as a rotation position detecting device. In contrast, the electric motor 1A according to an alternative embodiment has a Hall IC instead of the resolver 50 as a rotation position detecting device. In addition, the electric motor 1A according to another alternative embodiment is configured as a sensorless motor in which a rotation position detecting device is omitted. In the electric motor 1A according to the above other alternative embodiment, the resolver support portion 64 is omitted from the housing 60, and the fifth board portion 85 is omitted from the circuit board 80.

Next, technical ideas that can be understood from the above-described embodiments will be described together with advantageous effects.
A motor unit includes: a stator configured to form a magnetic field by a current supplied; a rotor including an output shaft and configured to rotate by the magnetic field of the stator; a bus bar to which a coil end portion of the stator is electrically connected; a resolver that protrudes toward a side across the bus bar from a side at which the stator is located; a motor housing that accommodates the stator and the bus bar and that includes an opening portion that is open at a side at which the bus bar is located with respect to the stator in an axial direction; a housing including a bottom wall that covers the opening portion and the resolver and a side wall that surrounds the resolver and that is mounted at the opening portion; a heat sink including a first heat dissipation wall portion upright from the bottom wall toward the stator and having a first heat dissipation principal surface; and a circuit board including a first board portion mounted on the first heat dissipation principal surface and having a first principal surface, and a power element mounted on the first principal surface, wherein the heat sink and the circuit board are located in a space surrounded by the bus bar, the resolver and the side wall.

With this configuration, the heat sink and the circuit board overlap with the resolver in the axial direction. Therefore, in comparison with a configuration that the heat sink and the circuit board are located in the distal end direction with respect to the resolver, it is possible to reduce the size of the motor unit in the axial direction.

A motor unit includes: a stator confgured to form a magnetic field, by a current supplied; a rotor including an output shaft and configured to rotate by the magnetic field of the stator; a worm shaft connected to the output shaft; a worm wheel configured to integrally rotate with a steering shaft and meshing with the worm shaft; a connection member that connects the worm shaft and the output shaft to each other; a gear housing that accommodates the worm wheel and the worm shaft; a heat sink including a first heat dissipation wall portion upright from the gear housing toward the stator at a location at which the heat sink overlaps with the connection member in an axial direction and having a first heat dissipation principal surface parallel to the connection member; and a circuit board including a first board portion connected to the first heat dissipation principal surface and having a first principal surface, and a power element mounted on the first principal surface.

With this configuration, the heat sink and the circuit board overlap with the connection member in the axial direction. Therefore, in comparison with a configuration that the heat sink and the circuit board are located in the proximal end direction with respect to the connection member, it is possible to reduce the size of the motor unit in the axial direction.

## Claims

1. A control device (1B, 200) **characterized by** comprising:
a housing (60, 210) having a bottom wall (62, 211), a side wall (61, 212) upright from the bottom wall, and an accommodation space (60A, 213) formed so as to be surrounded by the side wall;
a heat sink (70) accommodated in the accommodation space, and including a first heat dissipation wall portion (71) having a first heat dissipation principal surface (71A); and
a circuit board (80) including: a first board portion (81) connected to the first heat dissipation principal surface and having a first principal surface (81A); and a power element (81C) mounted on the first principal surface.

2. The control device according to claim 1, wherein
the heat sink is accommodated in the accommodation space, and includes a second heat dissipation wall portion (72) having a second heat dissipation principal surface (72A), and
the circuit board includes: a second board portion (82) connected to the second heat dissipation principal surface and having a second principal surface (82A); and a first coupling portion (86) that couples the first board portion and the second board portion to each other.

3. The control device according to claim 2, wherein
the first heat dissipation wall portion has a rectangular shape and is upright from the bottom wall, and includes: a first heat dissipation back surface (71B) that constitutes a surface across the first heat dissipation wall portion from the first heat dissipation principal surface; and a first one end portion (71X) and a first other end portion (71Y) extending in a direction in which the first heat dissipation wall portion is upright from the bottom wall,
the second heat dissipation wall portion has a rectangular shape and is upright from the bottom wall, and includes: a second heat dissipation back surface (72B) that constitutes a surface across the second heat dissipation wall portion from the second heat dissipation principal surface; and a second one end portion (72X) and a second other end portion (72Y) extending in a direction in which the second heat dissipation wall portion is upright from the bottom wall, the second one end portion being located adjacent to the first other end portion, and
the heat sink includes a first coupling wall portion (74) that couples the first other end portion and the second one end portion to each other, and that bends in a direction in which the first heat dissipation back surface and the second heat dissipation back surface face each other.

4. The control device according to claim 3, wherein
the heat sink is accommodated in the accommodation space, and includes a third heat dissipation wall portion (73) having a third heat dissipation principal surface (73A), and
the circuit board includes: a third board portion (83) mounted on the third heat dissipation principal surface and having a third principal surface (83A); and a second coupling portion (87) that couples the first board portion and the third board portion to each other.

5. The control device according to claim 4, wherein
the third heat dissipation wall portion has a rectangular shape and is upright from the bottom wall, and includes: a third heat dissipation back surface (73B) that constitutes a surface across the third heat dissipation wall portion from the third heat dissipation principal surface; and a third one end portion (73X) and a third other end portion (73Y) extending in a direction in which the third heat dissipation wall portion is upright from the bottom wall, the third one end portion being located adjacent to the first one end portion, the third heat dissipation back surface facing the second heat dissipation back surface via a space, and
the heat sink includes: a second coupling wall portion (75) that couples the first one end portion and the third one end portion to each other, and that bends in a direction in which the first heat dissipation back surface and the third heat dissipation back surface face each other.

6. The control device according to claim 4 or 5, wherein
the circuit board includes another power element (82C) on the second principal surface, and includes a control element (83C, 83D) on the third principal surface.

7. A control device (1B, 200) **characterized by** comprising:
a housing (60, 210) having a bottom wall (62, 211), a side wall (61, 212) upright from the bottom wall, and an accommodation space (60A, 213) formed so as to be surrounded by the side wall;
a heat sink (70) accommodated in the accommodation space, and including: a first heat dissipation wall portion (71) having a first heat dissipation principal surface (71A); and a second heat dissipation wall portion (72) having a second heat dissipation principal surface (72A); and
a circuit board (80) including: a first circuit board (81) mounted on the first heat dissipation principal surface and having a first principal surface (81A); a second circuit board (82) mounted on the second heat dissipation principal surface and having a second principal surface (82A); and a power element (81C) mounted on the first principal surface.

8. A motor unit (1) **characterized by** comprising the control device according to any one of claims 1 to 7.

9. A control device (415) that drives a three-phase brushless motor (1A), **characterized by** comprising:
a housing (60) having a bottom wall (62), a side wall (61) upright from the bottom wall, and an accommodation space (60A) formed so as to be surrounded by the side wall;
a heat sink (300) accommodated in the housing, and including a heat dissipation wall portion (310 to 370) having a heat dissipation principal surface (311 to 371);
a circuit board (400) mounted on the heat dissipation principal surface, and including a plurality of board portions (410 to 470) each having a principal surface (411 to 471); and
a plurality of inverter circuits formed on the principal surfaces for driving the three-phase brushless motor in multiple systems, wherein
the circuit board includes the board portions in number larger than or equal to three times of the number of the systems in which the three-phase brushless motor is driven, and
switching elements (423 to 473) of the phases of the inverter circuits are respectively mounted on the principal surfaces of the board portions.

10. The control device according to claim 9, wherein
the circuit board includes a board portion (410) having a principal surface (411) to which a connector (413, 414) for supplying electric power to the three-phase brushless motor is mounted.

11. The control device according to claim 9 or 10, wherein
the circuit board includes coupling portions (481 to 486), each of which couples the adjacent board portions.

12. A motor unit (1) **characterized by** comprising:
a three-phase brushless motor (1A); and
the control device according to any one of claims 9 to 11, wherein
the three-phase brushless motor includes a stator (20),
the plurality of inverter circuits include a first inverter circuit and a second inverter circuit,
the stator includes a first drive stator (20A) that is energized via the first inverter circuit and a second drive stator (20B) that is energized via the second inverter circuit,
the stator is split into the first drive stator and the second drive stator in a circumferential direction of the three-phase brushless motor,
the board portions (420 to 440) that constitute the first inverter circuit among the board portions are arranged at the same location in the circumferential direction as the first drive stator, and
the board portions (450 to 470) that constitute the second inverter circuit among the board portions are arranged at the same location in the circumferential direction as the second drive stator.
